# Europäisches Patentamt

## European Patent Office

## Office européen des brevets

(11) Veröffentlichungsnummer: **0 053 272**
**B2**

(12) **NEUE EUROPÄISCHE PATENTSCHRIFT**

(45) Veröffentlichungstag der neuen Patentschrift:
**08.11.89**

(21) Anmeldenummer: **81108820.2**

(22) Anmeldetag: **23.10.81**

(51) Int. Cl.⁴: **H 05 K 13/00,** H 05 K 13/08,
H 05 K 3/00

(54) Mehrlagen-Leiterplatte und Verfahren zur Ermittlung der Ist-Position innenliegender Anschlussflächen.

(30) Priorität: **02.12.80 DE 3045433**

(43) Veröffentlichungstag der Anmeldung:
**09.06.82 Patentblatt 82/23**

(45) Bekanntmachung des Hinweises auf die Patenterteilung:
**16.04.86 Patentblatt 86/16**

(45) Bekanntmachung des Hinweises auf die Entscheidung
über den Einspruch:
**08.11.89 Patentblatt 89/45**

(84) Benannte Vertragsstaaten:
**FR GB IT NL**

(56) Entgegenhaltungen:
**DE-A- 2 553 734**
**DE-A- 2 835 353**
**DE-A- 2 917 472**
**DE-A- 3 031 103**
**US-A- 3 428 872**
**US-A- 3 516 156**
**US-A- 3 564 114**
**US-A- 3 859 711**

**IBM TECHNICAL DISCLOSURE BULLETIN, Band 13, Nr.
1, Juni 1970, Seiten 131-132, New York, USA M.R.
MARASCH: "Delete tool with tester"**

(73) Patentinhaber: **Siemens Aktiengesellschaft,
Wittelsbacherplatz 2, D-8000 München 2 (DE)**

(72) Erfinder: **Brabetz, Bernhard, Dipl.-Ing., Dr.
Böttcherstrasse 33, D-8000 München 60 (DE)**

## Beschreibung

Die Erfindung bezieht sich auf ein Verfahren zur Ermittlung der Ist-Position innenliegender Anschlußflächen der einzelnen Lagen von Preßlingen mehrlagiger Leiterplatten mit elektrisch auswertbaren Testcoupons.

Einer der wichtigsten Arbeitsschritte bei der Herstellung von Mehrlagen-Leiterplatten ist das Bohren der Anschlußlöcher für die metallischen Durchverbindungen. Um die elektrische Funktion, die elektrische Sicherheit sowie die Zuverlässigkeit des Produktes «Mehrlagen-Leiterplatte» sicherzustellen, müssen diese Bohrungen zu den innenliegenden Anschlußflächen (z.B. Lötaugen) auf den Signallagen sowie den innenliegenden Freiätzungen auf den Potentiallagen innerhalb vorgegebener Toleranzen liegen.

Solche Toleranzforderungen sind notwendig, da im Fertigungsprozeß die mit den Bildelementen bedruckte Leiterplatte an den Kreuzungsstellen des Rasterfeldes gebohrt werden, wobei hierfür meist numerisch gesteuerte Bohrmaschinen, beispielsweise Mehrspindelbohrmaschinen, verwendet werden. Gegenüber den Bohrspindeln dieser Bohrmaschine wird die Leitungsplatte um Rasterschritte verfahren und gebohrt. Die Bohrungen sollen dabei weitgehend genau im Mittelpunkt etwa der Lötaugen zu liegen kommen. Bestimmte Mindestabstände zwischen Bohrungswand und Freiätzungsrand dürfen nicht unterschritten werden. Außerdem darf der Bohrungsrand die Anschlußfläche (z.B. Lötauge) nicht verlassen.

Entscheidend für die Lagegenauigkeit der erstellten Bohrungen ist dabei die mehr oder weniger große Übereinstimmung der Lage des Null- oder Bezugspunktes der nach einem vorbestimmten Programm arbeitenden Bohrmaschine innerhalb eines Koordinatensystems und damit der einzelnen Rasterschritte des Bohrtisches mit der Lage des Bezugspunktes im vorgegebenen Soll-Rasterfeld.

Sehr enge Toleranzbereiche sind insbesondere bei mehrlagigen gedruckten Leiterplatten zu fordern, da hierbei eine genaue Fluchtung in den verschiedenen Lagen Voraussetzung für deren Verwendbarkeit ist. Die möglichst genaue Kenntnis der Ist-Position der innenliegenden Anschlußflächen bzw. Freiätzungen zu einem Bezugspunkt (z.B. Aufnahmebohrung) ist Voraussetzung zur Erfüllung dieser Forderung.

Bisher hat man zur Lösung dieses Problems die Mehrlagen-Leiterplatte von einem Paßsystem aus bearbeitet. Das Paßsystem befindet sich auf jeder der Einzelfolien, aus welchen die Mehrlagen-Leiterplatte entsteht. Es besteht aus Aufnahmelöchern, die einen Bezugspunkt und eine Bezugslinie festlegen, von wo aus die Lagebestimmung der Leiterbilder auf den Einzelfolien erfolgt. Auch beim Verpressen der Einzelfolien wird dieses Paßsystem verwendet, so daß die Leiterbilder der einzelnen Innenlagen nach dem Verpressen auf einer nominal bekannten Position zum Aufnahmesystem liegen. Beim Bohren der Anschlußlöcher erfolgt deren Positionierung ebenfalls in bezug auf das Paßsystem, wobei in den meisten Fällen die nominale Lage der innenliegenden Leiterbilder zum Paßsystem beim Positionieren der Anschlußlöcher Anwendung findet.

Da die tatsächliche Position (Ist-Position) der innenliegenden Leiterbilder aufgrund von Fertigungsfehlern und Längenänderungen nicht mit der nominalen Position übereinstimmt, ist bei dieser Vorgehensweise die Zuordnung der Anschlußlöcher zu den innenliegenden Leiterbildern fehlerbehaftet. Verschiedentlich wird deshalb auch versucht, den Unterschied zwischen Ist-Position und Nominal-Position vor dem Bohren direkt am Werkstück – dem Preßling – zu ermitteln und das Bohrbild dann entsprechend zu korrigieren. Die bekannten Methoden zur Ermittlung der Ist-Position (z.B. Röntgen) arbeiten mit einer Genauigkeit von ± 0,1 mm oder größer. Bei der Bearbeitung hochminiaturisierter Leiterbilder werden aber neuerdings Genauigkeiten im µm-Bereich verlangt.

Aus der Patentschrift US 3 564 114 ist eine Mehrlagen-Leiterplatte bekannt, bei der jeder Kern mit einem Testcoupon versehen ist. Dieser ist jedoch nicht Bestandteil des Leiterbildes, womit der geometrische Bezug zwischen Testcoupon und Leiterbild durch Toleranzen aus der Fertigung oder Montage behaftet ist.

Der Erfindung liegt die Aufgabe zugrunde, ein Verfahren zur Ermittlung der Ist-Position innenliegender Leiterbilder zur Verfügung zu stellen, womit Maßtoleranzen im µm-Bereich zu bewältigen sind.

Die Lösung dieser Aufgabe wird durch den kennzeichnenden Teil des Anspruches 1 wiedergegeben.

Nach einer Weiterbildung der Erfindung besteht der Testcoupon aus einem Streifen leitender Folie, in der ein Freiätzungsgraben angeordnet ist. Die symmetrische Gestaltung des Testcoupons hat den Vorteil, daß Formfehler am Testcoupon, die durch Über- bzw. Unterätzen des Leiterbildes verursacht sind, sich nicht auf die Lage der Mitte des Freiätzungsgrabens auswirken und somit ohne Einfluss auf die Positionsaussage sind.

Statt des Freiätzungsgrabens kann nach einer weiteren Ausgestaltung der Erfindung ein mit leitender Folie bedeckter Bereich vorgesehen sein, dessen Umgebung frei von leitender Folie bleibt. Auch bei dieser Ausgestaltung handelt es sich um eine symmetrische Ausführung, bei der die Mitte der leitenden Folie bestimmt wird.

Nach einer Weiterbildung der Erfindung sind zwei oder mehrere Testcoupons je Koordinatenrichtung und Leiterbild vorgesehen. Dadurch ist es möglich, diejenigen Innenlagen, welche die höchsten Toleranzanforderungen haben, gezielt mit Hilfe ihrer Testcoupons in ihrer Position abzufragen.

Nach einer Weiterbildung der Erfindung sind die Testcoupons entlang und möglichst nahe den Außenkonturen des Leiterbildes angeordnet.

Nach einer weiteren Ausgestaltung des Verfahrens wird die Lage der Probebohrungen elektrisch abgefragt. Auf diese Weise ist möglich, das Abfrageergebnis on line mit Hilfe einer Auswerteelektronik zu verarbeiten und in eine Maschinensteuerung einzugeben.

Nach dem erfindungsgemäßen Verfahren werden die Innenlagen einzeln oder in frei festlegbaren Gruppen ausgewertet. Auf diese Weise ist es möglich, die Innenlage, die die größte Toleranzforderung aufweist, einzeln abzufragen.

Die Erfindung wird anhand der Figuren erläutert. Es zeigen: Figur 1 die Innenlage eines Kerns mit vier Testcoupons, Figur 2 und 3 zwei Ausführungsmöglichkeiten eines Testcoupons, Figur 4 einen Testcoupon mit gestaffelt angeordneten Bohrungen und Figur 5 und 6 Bestimmung der Ist-Position je Innenlage an zwei Ausführungsbeispielen.

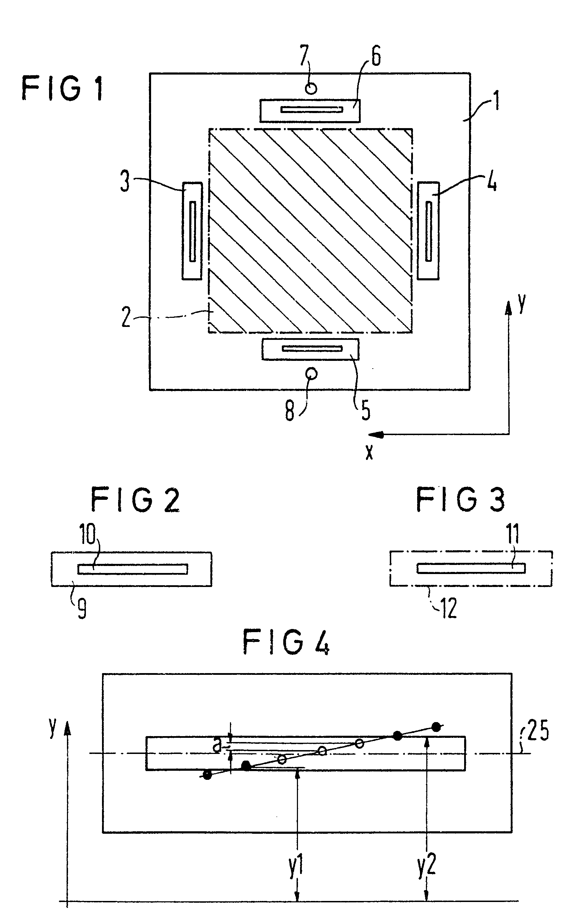

In der Figur 1, die die sinnvolle Anordnung und Gestaltung von Testcoupons zeigt, ist mit 1 ein Kern bezeichnet. Im Bereich 2, der strichpunktiert umrandet ist, befindet sich ein schraffiert angedeutetes Leiterbild. Neben dem Leiterbild sind als Ausführungsbeispiele zwei Testcoupons 3, 4 zur Ermittlung der Ist-Position in x-Richtung angeordnet. Zur Bestimmung der Ist-Position in y-Richtung dienen die Testcoupons 5, 6. Zum Aufspannen des späteren Laminats beim Bohren sind Aufnahmelöcher 7, 8 vorgesehen.

Nach der Figur 2 besteht ein Testcoupon z.B. aus einem mit leitender Folie 9 bedeckten Bereich, in dem ein Freiätzungsgraben 10 angeordnet ist. Nach der inversen Ausführung gemäß Figur 3 wird der Freiätzungsgraben 10 zu einem mit leitender Folie bedeckten Bereich 11, dessen Umgebung (Umrandung) 12 frei ist von leitender Folie.

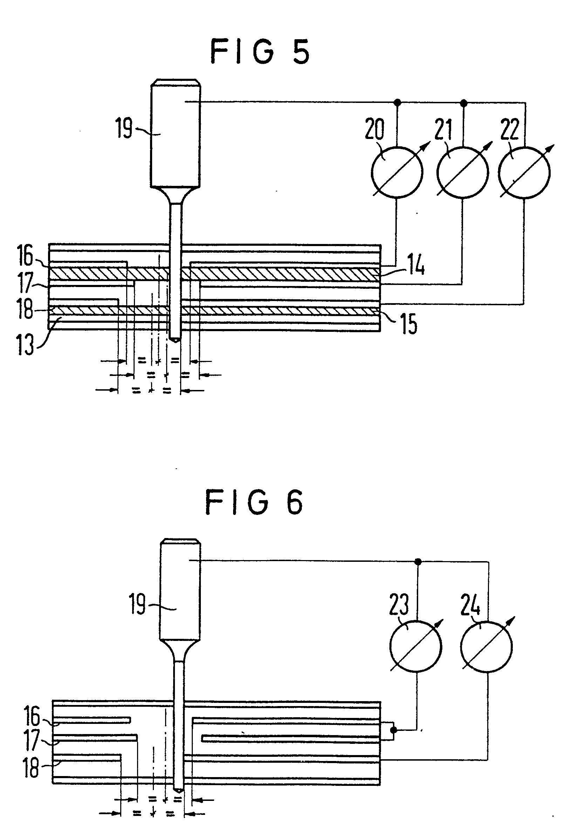

Die Figur 4 zeigt vergrößert einen der Testcoupons, z.B. 5, zur Ermittlung der Position in y-Richtung. Mit a ist die Größe der Positionsstaffelung in In den Figuren 5 und 6 wird die Bestimmung der Ist-Position je Innenlage veranschaulicht. Mit 13 ist jeweils ein Preßling bezeichnet, der z.B. nach der Figur 5 die Kerne 14 und 15 einschließt. Der Kern 14 weist eine Innenlage 16 und 17 und der Kern 15 eine Innenlage 18 auf. Ein Bohrer 19 ist nach der Figur 5 über Widerstandsmeßgeräte 20, 21, 22 mit den Innenlagen verbunden. Nach der Figur 6 sind die Innenlagen 16 und 17 zusammengefaßt, so daß nur zwei Widerstandsmeßgeräte 23 und 24 erforderlich sind. Die Widerstandsmeßgeräte müssen zur kurzzeitigen Anzeige von Signalen geeignet sein.

Unmittelbar vor dem Bohren der Anschlußlöcher werden in den Coupon Testbohrungen abgesetzt. Dabei wird überwacht, ob der Bohrer in elektrischen Kontakt zum leitenden Bereich des Testcoupons kommt (Figur 5 und 6). Durch eine frei wählbare Staffelung um den Betrag a der Position der Testbohrungen kann so der Abstand der Mitte des Freiätzungsgrabens 10 des Testcoupons zu einem Referenzpunkt (z.B. Maschinennullpunkt oder Aufnahmeloch) bestimmt werden. Die Größe der Positionsstaffelung a der Testbohrungen bestimmt die Genauigkeit, mit welcher die Ist-Lage der Mitte des Freiätzungsgrabens ermittelt werden kann. Nach der Darstellung in der Figur 4 wird die Position der Mitte des Freiätzungsgrabens 25 mit einer Genauigkeit von $\leq 1/2$ a angezeigt. Die y-Position des Freiätzungsgrabens ist $1/2\ (y1+y2)$. Beim Erzeugen der als schwarzen Punkt gezeichneten Bohrungen kommt der Bohrer in elektrischen Kontakt zum leitenden Bereich des Testcoupons. Beim Erzeugen der mit einem kleinen Kreis gekennzeichneten Bohrungen kommt der Bohrer nicht in elektrischen Kontakt zum leitenden Bereich des Testcoupons.

Ordnet man zwei Testcoupons je Koordinatenrichtung und Leiterbild an, so kann der tatsächliche Abstand der Testcoupons zueinander nach der Ermittlung ihrer Ist-Lage berechnet werden. Bei Anordnung des Testcoupons entlang den Außenkonturen des Leiterbildes (Figur 1) kann so neben der tatsächlichen Position auch die tatsächliche Größe des Leiterbildes je Innenlage bestimmt werden.

Durch geeignete Wahl der elektrischen Abfrage ist es möglich, die Testcoupons je Innenlage oder für beliebige Innenlagengruppen abzufragen (Figur 5 und 6).

Nach Ermittlung der Ist-Positionen der Testcoupons des Preßlings in einem vorgeschalteten Bohrgang können die Anschlußlöcher in derselben Aufspannung entsprechend dieser Ergebnisse eingebracht werden. Je nach Bedarf können sie jetzt für eine bestimmte Einzellage, eine Einzellagengruppe oder den genannten Innenlagenverband in ihrer Positionierung angepaßt werden. Dies geschieht an Bohrmaschinen in der Steuerung durch Nullpunktverschiebung und/oder durch die Anwendung eines Skalenfaktors. Die einzelnen Bohrkoordinaten werden dabei in beiden Achsen mit einem Faktor multipliziert. Damit ist es möglich, lineare Längenänderungen des Bohrrasters vorzunehmen.

**Patentansprüche**

1. Verfahren zur Ermittlung der Ist-Position innenliegender Anschlußflächen der einzelnen Lagen von Preßlingen mehrlagiger Leiterplatten mit elektrisch auswertbaren Testcoupons, dadurch gekennzeichnet, daß durch gestaffelte Probebohrungen in den elektrisch auswertbaren Testcoupons (3 bis 6), die fertigungstechnisch Bestandteil des Leiterbildes sind, die Mitte (25) eines in den Testcoupons (3 bis 6) angeordneten Freiätzungsgrabens (10) zu einem Referenzpunkt durch Beobachtung des elektrischen Kontaktes (20 bis 22, 23 und 24) zwischen einem Bohrer (19) und der Innenlage (16 bis 18) bestimmt wird.

2. Verfahren nach Anspruch 1, dadurch gekennzeichnet, daß der elektrisch auswertbare Testcoupon (3 bis 6) aus einem Streifen leitender Folie (9) besteht, in der ein linearer Freiätzungsgraben (10, Figur 2) angeordnet ist, der orthogonal auf der Koordinatenrichtung steht, für welche die Position ermittelt werden soll.

3. Verfahren nach Anspruch 2, dadurch gekennzeichnet, daß statt des Freiätzungsgrabens ein mit leitender Folie bedeckter Bereich (11) vorgesehen ist, dessen Umgebung (12) frei von leitender Folie bleibt (Figur 3).

4. Verfahren nach Anspruch 1, dadurch gekennzeichnet, daß zwei oder mehrere elektrisch auswertbare Testcoupons (3 bis 6) je Koordinatenrichtung (x, y) und Leiterbild (2) vorgesehen sind.

5. Verfahren nach den Ansprüchen 1 bis 4, dadurch gekennzeichnet, daß die elektrisch auswertbaren Testcoupons entlang und möglichst nahe den Außenkonturen des Leiterbildes angeordnet sind.

6. Verfahren nach Anspruch 1, dadurch gekennzeichnet, daß die Lage der Probebohrungen elektrisch abgefragt wird.

7. Verfahren nach Anspruch 1, dadurch gekennzeichnet, daß die Innenlagen (16 bis 18) einzeln oder in frei festlegbaren Gruppen ausgewertet werden.

## Claims

1. Method of establishing the actual position of internal contact areas of the individual layers of mouldings of multilayer printed-circuit boards with electrically evaluable test coupons characterized in that by means of staggered test drill holes in the electrically evaluable test coupons (3 to 6), which in terms of production engeneering are a component of the conductive pattern, the middle (25) of a clearance trench (10) arranged in the test coupons (3 to 6) is determined as a reference point by observing the electrical contact (20 to 22, 23 and 24) between a drill (19) and the internal layer (16 to 18).

2. Method according to Claim 1, characterized in that the test coupon (3 to 6) consists of a strip of conductive foil (9), in which there is arranged a linear clearance trench (10, figure 2), which lies orthogonally on the coordinate direction for which the position is to be established.

3. Method according to Claim 2, characterized in that, instead of the clearance trench, a zone (11) covered with conductive foil is provided, the surroundings (12) of which remain free from conductive foil (3).

4. Method according to Claim 1, characterized in that two or more electrically evaluable test coupons (3 to 6) are provided per coordinate direction (x, y) and conductive pattern (2).

5. Method according to Claims 1 to 4, characterized in that the electrically evaluable test coupons are arranged along and as near as possible to the external contours of the conductive pattern.

6. Method according to Claim 1, characterized in that the position of the test drill holes is interrogated electrically.

7. Method according to Claim 1, characterized in that the internal layers (16 to 18) are evaluated individually or in freely definable groups.

## Revendications

1. Procédé pour déterminer la position réelle de surfaces intérieures de raccordement des différentes couches d'ébauches de plaquettes à circuits imprimés multicouches au moyen de coupons de contrôle exploitables électriquement, caractérisé en ce que, par des perçages d'essai échelonnés dans les coupons de contrôle (3 à 6), exploitables électriquement et qui font partie, du point de vue de la technique de fabrication, du modèle de circuit, on détermine le milieu (25) d'une rainure (10) dégagée par attaque chimique dans les coupons de contrôle (3 à 6), par rapport à un point de référence, par observation du contact électrique (20 à 22, 23 et 24) entre un foret (19) et de la couche intérieure (16 à 18).

2. Procédé selon la revendication 1, caractérisé en ce que le coupon de contrôle (3 à 6) exploitable électriquement est formé par une bande d'une feuille conductrice (9), dans laquelle est ménagée une rainure linéaire (10, figure 2) dégagée par attaque chimique et perpendiculaire à la direction de coordonnées pour laquelle la position doit être déterminée.

3. Procédé selon la revendication 2, caractérisé en ce que, à la place de la rainure dégagée par attaque chimique, on a prévu une zone (11) recouverte par une feuille conductrice et dont l'entourage (12) reste exempt de feuille conductrice (figure 3).

4. Procédé selon la revendication 1 caractérisé en ce que l'on prévoit deux ou davantage de coupons de contrôle (3 à 6) exploitables électriquement pour chaque direction de coordonnées (x, y) et pour chaque modèle de circuit (2).

5. Procédé selon les revendications 1 à 4, caractérisé en ce que l'on dispose les coupons de contrôle exploitables électriquement le long des contours extérieurs du modèle de circuit et aussi près que possible de ces contours.

6. Procédé selon la revendication 1, caractérisé en ce que l'on interroge la position des perçages d'essai par voie électrique.

7. Procédé selon la revendication 1, caractérisé en ce que l'on évalue les couches intérieures (16 à 18) individuellement ou en groupes pouvant être déterminés librement.

FIG 1

FIG 2

FIG 3

FIG 4

# FIG 5

# FIG 6